(19) Europäisches Patentamt
European Patent Office
Office européen des brevets

(11) **EP 4 756 446 A1**

(12) **DEMANDE DE BREVET EUROPEEN**

(43) Date de publication:
**10.06.2026 Bulletin 2026/24**

(21) Numéro de dépôt: **25220528.1**

(22) Date de dépôt: **03.12.2025**

(51) Classification Internationale des Brevets (IPC):
*G01R 31/367* (2019.01) *G01R 31/392* (2019.01)

(52) Classification Coopérative des Brevets (CPC):
**G01R 31/367; G01R 31/392**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **06.12.2024 FR 2413593**

(71) Demandeur: **SAFT**
**92300 Levallois-Perret (FR)**

(72) Inventeurs:
• **MONIER-REYES, Daniel**
**33480 Avensan (FR)**
• **BENJAMIN, Sébastien**
**33850 Léognan (FR)**
• **BERTIN, Clément**
**33300 Bordeaux (FR)**

(74) Mandataire: **Lavoix**
**2, place d'Estienne d'Orves**
**75441 Paris Cedex 09 (FR)**

(54) **PROCÉDÉ EMBARQUABLE D'ANALYSE DE LA DÉRIVÉE D'UNE GRANDEUR ÉLECTRIQUE D'AU MOINS UN ÉLÉMENT ÉLECTROCHIMIQUE, PROCÉDÉ ET DISPOSITIFS ASSOCIÉS**

(57) La présente invention concerne un procédé d'analyse de la dérivée d'une première grandeur électrique relative à au moins un élément électrochimique (12) par rapport à une deuxième grandeur électrique lors d'une charge ou d'une décharge à courant constant ou puissance constante, le procédé comprenant les étapes de :
- obtention d'un signal temporel de la première grandeur électrique,
- échantillonnage du signal selon un premier intervalle de temps d'échantillonnage,
- filtrage du premier signal échantillonné,

- échantillonnage du signal filtré selon un deuxième intervalle de temps d'échantillonnage strictement supérieur au premier intervalle de temps d'échantillonnage,
- dérivation du deuxième signal échantillonné par rapport à la deuxième grandeur électrique, et
- détection d'une valeur d'un paramètre relatif à au moins un motif prédéfini dans le signal dérivé.

FIG.1

EP 4 756 446 A1

**Description**

La présente invention concerne un procédé d'analyse de la dérivée d'une première grandeur électrique relative à au moins un élément électrochimique (notamment la tension ou une charge accumulée) par rapport à une deuxième grandeur électrique (notamment la tension ou une charge accumulée) lors d'une charge ou d'une décharge à courant constant.

La présente invention se rapporte aussi à un procédé d'estimation d'un paramètre relatif à l'état de santé d'au moins un élément électrochimique d'une batterie utilisant le procédé d'analyse.

La présente invention concerne également les dispositifs impliqués dans la mise en œuvre de tels procédés à savoir : un calculateur, un système de gestion et une batterie associés.

Typiquement une batterie comprend un ou plusieurs accumulateurs de courant appelés aussi générateurs électrochimiques, cellules ou éléments. Un accumulateur est un dispositif de production d'électricité dans lequel de l'énergie chimique est convertie en énergie électrique. L'énergie chimique provient des composés électrochimiquement actifs déposés sur au moins une face d'électrodes disposées dans l'accumulateur. L'énergie électrique est produite par des réactions électrochimiques au cours d'une décharge de l'accumulateur. Les électrodes, disposées dans un conteneur, sont connectées électriquement à des bornes de sortie de courant qui assurent une continuité électrique entre les électrodes et un consommateur électrique auquel l'accumulateur est associé.

Afin d'augmenter la puissance électrique délivrée, on peut associer plusieurs accumulateurs étanches entre eux pour former une batterie. Ainsi, une batterie peut être divisée en modules, chaque module étant composé d'un ou plusieurs accumulateurs reliés entre eux en série et/ou en parallèle. Ainsi, une batterie peut par exemple comporter une ou plusieurs branches parallèles d'accumulateurs reliés en série et/ou une ou plusieurs branches parallèles de modules reliés en série.

Un circuit de charge est généralement prévu auquel la batterie peut être branchée pour recharger les accumulateurs.

Par ailleurs, un système de gestion électronique comprenant des capteurs de mesures et un circuit électronique de contrôle, plus ou moins évolué selon les applications, peut être associé à la batterie. Un tel système permet notamment d'organiser et de contrôler la charge et la décharge de la batterie, pour équilibrer la charge et la décharge des différents accumulateurs de la batterie les uns par rapport aux autres.

L'état de santé est une information utile au système électronique de gestion de la batterie pour optimiser son utilisation et sa durée de vie. L'état de santé est souvent désigné sous l'abréviation SOH qui renvoie à la dénomination anglaise de « State of Health ».

L'état de santé SOH permet d'estimer le vieillissement de la batterie entre un état neuf et un état fin de vie, ou plus généralement, entre un état initial et un état final.

En ce sens, l'état de santé SOH définit l'aptitude de la batterie à fournir un courant.

Une technique de détermination de l'état de santé SOH est une technique dans laquelle les valeurs de température, de tension, et éventuellement de courant de la batterie sont surveillées pour déterminer une valeur de l'état de santé SOH à partir de lois de vieillissement. De telles lois de vieillissement sont obtenues à partir d'essais réalisés en laboratoire. L'application des lois de vieillissement aux valeurs surveillées donne ainsi une estimation du vieillissement de la batterie.

Toutefois, cette technique ne prend pas en compte les différents mécanismes rendant le vieillissement des accumulateurs de la batterie non linéaires et/ou inhomogènes.

De plus, une telle technique ne permet pas de gérer la disparité de vieillissement entre les éléments.

Il est également connu d'analyser la dérivée de la tension de chaque élément par rapport aux Ampères heures lors d'une charge ou d'une décharge à courant constant relativement faible. Plus ce courant est faible et plus la dérivée contient d'information relative au vieillissement de l'élément considéré, au détriment du temps de calcul et du temps de maintenance impliqués. Des valeurs comprises entre C/3 et C/10 sont souvent utilisées en embarqué pour limiter le temps pris par un cycle de maintenance.

À partir de cette dérivée, on effectue une détection de pics dont le type correspond à des transitions de phases, en particulier des phases cristallographiques, qui ont lieu au sein de l'élément durant la charge ou la décharge.

Par exemple, pour une chimie de type LFP/graphite, la transition $LiC_6$ de/vers $LiC_{12}$ est une transition de phase impliquant un pic remarquable. La transition entre $LiC_{12}$ et $LIC_6$ (sens $LIC_6$ de $LIC_{12}$) a lieu en charge alors que la transition entre $LiC_6$ et $LiC_{12}$ (sens $LIC_6$ vers $LIC_{12}$) a lieu en décharge.

Une telle analyse est souvent dénommée analyse DVA, l'abréviation DVA renvoyant à la dénomination anglaise correspondante de « *Differential Voltage Analysis* ».

Pour un type de vieillissement donné, on sait associer à la position de certains pics (en Ah écoulés depuis le début du cycle de maintenance) la capacité de l'élément grâce à une table préalablement établie.

Dans certains cas du fait que le pic disparaît avec le vieillissement (c'est notamment le cas de la transition $LiC_6$ de/vers $LiC_{12}$) ou a contrario qu'il apparaît, la technique DVA peut utiliser simultanément plusieurs pics.

Toutefois, un tel procédé ne peut pas être mis en œuvre de manière embarquée.

En effet, la mesure de tension de l'élément est bruitée et crénelée dû au capteur de tension et à l'acquisition opérée par le convertisseur analogique/numérique. Ceci implique le recours à des traitements de filtrage complexes de type Savitzky-Golay, ce qui suppose la capacité à réaliser des calculs lourds et à mémoriser de grandes quantités d'information car ces traitements ont besoin de l'entièreté de la courbe dérivée pour filtrer.

Il existe un besoin pour un procédé d'analyse de la dérivée d'une première grandeur électrique relative à au moins un élément électrochimique (notamment une tension) par rapport à une deuxième grandeur électrique relative à l'au moins un élément électrochimique (notamment une quantité de charge) lors d'une charge ou d'une décharge à courant constant qui soit embarquable et robuste, notamment à des fins d'estimation d'un paramètre relatif à l'état de santé d'un élément électrochimique.

A cet effet, la description a pour objet un procédé d'analyse de la dérivée d'une première grandeur électrique relative à au moins un élément électrochimique par rapport à une deuxième grandeur électrique relative à l'au moins un élément électrochimique lors d'une charge ou d'une décharge à courant constant ou puissance constante, le procédé d'analyse étant mis en œuvre par un calculateur d'un système de gestion de l'au moins un élément électrochimique d'une batterie, le procédé d'analyse comprenant les étapes de :

- obtention d'un signal temporel de la première grandeur électrique relative à l'au moins un élément électrochimique,
- échantillonnage du signal temporel obtenu selon un premier intervalle de temps d'échantillonnage pour obtenir un premier signal échantillonné,
- filtrage du premier signal échantillonné, pour obtenir un signal filtré,
- échantillonnage du signal filtré selon un deuxième intervalle de temps d'échantillonnage, pour obtenir un deuxième signal échantillonné, le deuxième intervalle de temps d'échantillonnage étant strictement supérieur au premier intervalle de temps d'échantillonnage,
- dérivation du deuxième signal échantillonné par rapport à la deuxième grandeur électrique, pour obtenir un signal dérivé présentant une composante lente et une composante rapide, et
- détection d'une valeur d'un paramètre relatif à au moins un motif prédéfini dans le signal dérivé, la détection comprenant l'obtention de la composante lente du signal dérivé par application d'un filtre sur le signal dérivé, la présence éventuelle d'un motif prédéfini étant déterminée en utilisant la composante lente obtenue.

Suivant d'autres aspects avantageux, le procédé d'analyse comprend une ou plusieurs des caractéristiques suivantes, prises isolément ou suivant toutes les combinaisons techniquement possibles :

- l'étape de dérivation comporte une sous-étape de calcul de la dérivée, pour obtenir un signal intermédiaire et une sous-étape de filtrage du signal intermédiaire par application d'un filtre, pour obtenir le signal dérivé.
- l'étape de détection comporte l'obtention de zones d'intérêt où le motif prédéfini est potentiellement présent par détermination des instants durant lesquels une condition portant sur la différence entre le signal dérivé et le minimum entre la composante lente du signal dérivée et le signal dérivé est vérifiée.
- l'étape de détection comporte la détermination de la présence effective ou non d'un motif prédéfini dans les zones d'intérêt obtenues par vérification si le motif prédéfini potentiellement présent respecte une ou plusieurs caractéristiques attendues, une caractéristique étant de préférence relative à la largeur de la zone d'intérêt.
- le paramètre relatif à au moins un motif prédéfini dont la valeur est détectée lors de l'étape de détection est la position du motif prédéfini.
- lors de l'étape de filtrage, il est utilisé un filtre d'ordre deux.
- le filtre d'ordre deux est la composée de deux sous-filtres d'ordre un et identiques.
- chaque sous-filtre présente la fonction de filtrage suivante :

$$S_{SF}(n) = \frac{a_{SF}.S_{SF}(n-1) + e_{SF}(n)}{1 + a_{SF}}$$

Où :

- $S_{SF}(n)$ désigne la sortie du sous-filtre à l'instant n,
- $a_{SF}$ est un paramètre,
- $S_{SF}(n-1)$ désigne la sortie du sous-filtre à l'instant n-1, et
- $e_{SF}(n)$ désigne l'entrée du sous-filtre à l'instant n.

- le filtre appliqué à la sous-étape de filtrage et le filtre appliqué à l'étape de filtrage sont chacun composés des mêmes sous-filtres dont seuls le paramètre des sous-filtres varie.

- l'une des deux grandeurs électriques est la quantité de charge et l'autre grandeur électrique est la tension.

La description a également pour objet un procédé d'estimation d'un paramètre relatif à l'état de santé d'au moins un élément électrochimique d'une batterie, le procédé d'estimation étant mis en œuvre par un calculateur d'un système de gestion de l'au moins un élément électrochimique d'une batterie, le procédé d'estimation comprenant les étapes de :

- mise en œuvre d'un procédé d'analyse de la dérivée d'une première grandeur électrique relative à au moins un élément électrochimique par rapport à une deuxième grandeur électrique relative à l'au moins un élément électrochimique lors d'une charge ou d'une décharge à courant constant, pour obtenir au moins une valeur d'un paramètre relatif à au moins un motif prédéfini dans la dérivée de la première grandeur électrique, le procédé d'analyse étant un procédé tel que précédemment décrit, et
- estimation d'un paramètre relatif à l'état de santé d'au moins un élément électrochimique d'une batterie à partir de l'au moins un paramètre relatif à au moins un motif prédéfini dans la dérivée de la première grandeur électrique.

Suivant d'autres aspects avantageux, les procédés précédemment décrits comprennent une ou plusieurs des caractéristiques suivantes, prises isolément ou suivant toutes les combinaisons techniquement possibles :

- l'au moins un élément électrochimique présente au moins une transition de phase.
- l'au moins un élément électrochimique comprend un matériau actif cathodique comprenant un phosphate lithié de fer, un phosphate lithié de manganèse et de fer ou un fluoro-phosphate lithié de vanadium.
- l'au moins un élément électrochimique comprend un matériau actif anodique comprenant du graphite.

La description concerne aussi un calculateur propre à analyser la dérivée d'une première grandeur électrique relative à au moins un élément électrochimique par rapport à une deuxième grandeur électrique relative à l'au moins un élément électrochimique lors d'une charge ou d'une décharge à courant constant ou puissance constante, le calculateur faisant partie d'un système de gestion de l'au moins un élément électrochimique d'une batterie, le calculateur étant propre à :

- obtenir un signal temporel de la première grandeur électrique relative à l'au moins un élément électrochimique,
- échantillonner le signal temporel obtenu selon un premier intervalle de temps d'échantillonnage pour obtenir un premier signal échantillonné,
- filtrer le premier signal échantillonné, pour obtenir un signal filtré,
- échantillonner le signal filtré selon un deuxième intervalle de temps d'échantillonnage, pour obtenir un deuxième signal échantillonné, le deuxième intervalle de temps d'échantillonnage étant strictement supérieur au premier intervalle de temps d'échantillonnage,
- dériver le deuxième signal échantillonné par rapport à la deuxième grandeur électrique, pour obtenir un signal dérivé présentant une composante lente et une composante rapide, et
- détecter une valeur d'un paramètre relatif à au moins un motif prédéfini dans le signal dérivé en obtenant la composante lente du signal dérivé par application d'un filtre sur le signal dérivé, la présence éventuelle d'un motif prédéfini étant déterminée en utilisant la composante lente obtenue.

La description concerne porte aussi sur un calculateur propre à estimer un paramètre relatif à l'état de santé d'au moins un élément électrochimique d'une batterie, le calculateur faisant partie d'un système de gestion de l'au moins un élément électrochimique d'une batterie , le calculateur étant propre à :

- mettre en œuvre un procédé d'analyse de la dérivée d'une première grandeur électrique relative à au moins un élément électrochimique par rapport à une deuxième grandeur électrique relative à l'au moins un élément électrochimique lors d'une charge ou d'une décharge à courant constant, pour obtenir au moins une valeur d'un paramètre relatif à au moins un motif prédéfini dans la dérivée de la première grandeur électrique, le procédé d'analyse étant tel que précédemment décrit, et
- estimer un paramètre relatif à l'état de santé d'au moins un élément électrochimique d'une batterie à partir de l'au moins un paramètre relatif à au moins un motif prédéfini dans la dérivée de la première grandeur électrique.

La description a également pour objet un système de gestion d'au moins un élément électrochimique d'une batterie, l'au moins un élément électrochimique présentant des bornes, le système de gestion comprenant :

- un capteur de courant propre à appliquer mesurer le courant fourni par ledit au moins un élément électrochimique,
- un capteur de tension propre à mesurer la tension aux bornes de l'au moins un élément électrochimique, et

- un calculateur tel que précédemment décrit.

La description concerne aussi une batterie comprenant :

- au moins un élément électrochimique, et
- un système de gestion tel que précédemment décrit.

Dans la présente description, l'expression « propre à » signifie indifféremment « adapté pour », « adapté à » ou « configuré pour ».

L'invention apparaîtra plus clairement à la lecture de la description qui va suivre, donnée uniquement à titre d'exemple non limitatif, et faite en référence aux dessins dans lesquels :

- la figure 1 est une représentation schématique d'un exemple de batterie comportant un élément électrochimique,
- la figure 2 est un ordinogramme d'un exemple de mise en œuvre d'un procédé d'analyse de la dérivée de la tension d'au moins un élément électrochimique, et
- les figures 3 à 9 illustrent les signaux obtenus à différents stades de la mise en œuvre du procédé selon la figure 2.

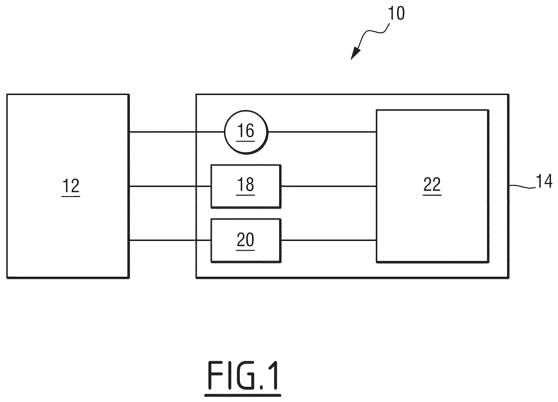

Une batterie 10 est représentée sur la figure 1.

De manière connue en soi, une batterie est généralement un agencement d'une pluralité d'éléments électrochimiques mais dans un souci de simplification du propos, il est décrit un cas à un seul élément électrochimique dans ce qui suit, sachant que la transposition à d'autres agencements est immédiate.

La batterie 10 comporte un élément électrochimique 12 et un système de gestion 14 de l'élément électrochimique 12.

Comme expliqué précédemment, un élément électrochimique 12 est un dispositif de production d'électricité dans lequel de l'énergie chimique est convertie en énergie électrique.

L'élément électrochimique 12 délivre donc un courant et une tension entre deux bornes.

De préférence, l'élément électrochimique 12 est un élément électrochimique avec un matériau actif cathodique comprenant un phosphate lithié de fer (LFP) ou un phosphate lithié de manganèse et de fer (LMFP) ou un fluorophosphate lithié de vanadium (LVPF).

Selon un autre mode de réalisation, l'un élément électrochimique 12 comprend un matériau actif anodique comprenant du graphite.

Bien entendu, ces exemples sont non limitatifs et le procédé décrit ultérieurement pourra être utilisé pour n'importe quel type d'élément électrochimique 12.

Le système de gestion 14 comporte un capteur de courant 16, un capteur de tension 18, un capteur de la température 20 et un calculateur 22.

Le capteur de courant 16 est propre à mesurer le courant fourni par l'élément électrochimique 12 ou appliqué à l'élément électrochimique 12 selon que l'on soit en décharge ou en charge.

Le capteur de tension 18 est propre à mesurer la tension aux bornes de l'élément électrochimique 12.

Le capteur de température 20 sert à mesurer la température de l'élément électrochimique 12.

Le calculateur 22 est propre à mettre en œuvre un procédé d'estimation d'un paramètre relatif à l'état de santé de l'élément électrochimique 12.

Dans l'exemple qui va être décrit, le paramètre relatif à l'état de santé est la capacité, de sorte que le calculateur 22 met ici en œuvre un procédé de détermination de la capacité de l'élément électrochimique 12.

Le calculateur 22 est un circuit électronique conçu pour manipuler et/ou transformer des données représentées par des quantités électroniques ou physiques dans des registres du calculateur et/ou des mémoires en d'autres données similaires correspondant à des données physiques dans les mémoires de registres ou d'autres types de dispositifs d'affichage, de dispositifs de transmission ou de dispositifs de mémorisation.

En tant qu'exemples spécifiques, le calculateur 22 comprend un processeur monocœur ou multicœurs (tel qu'une unité de traitement centrale (CPU), une unité de traitement graphique (GPU), un microcontrôleur et un processeur de signal numérique (DSP)), un circuit logique programmable, comme un circuit intégré spécifique à une application (ASIC), un réseau de portes programmables *in situ* (FPGA), un dispositif logique programmable (PLD) et des réseaux logiques programmables (PLA), une machine à états, une porte logique et des composants matériels discrets.

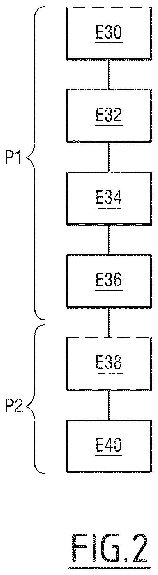

Un exemple de mise en œuvre du procédé d'estimation de la capacité de l'élément électrochimique 12 est maintenant décrit en référence à l'ordinogramme de la figure 2.

Le procédé d'estimation comporte une phase de détection de pics (phase P1) et une phase d'estimation de la capacité (phase P2).

Selon l'exemple décrit, la phase de détection P1 comporte une étape d'acquisition E30, une étape de filtrage E32, une étape de dérivation E34 et une étape de détection E36.

Lors de l'étape d'acquisition E30, la tension et le courant sont acquis respectivement par le capteur de tension 18 et le capteur de courant 16.

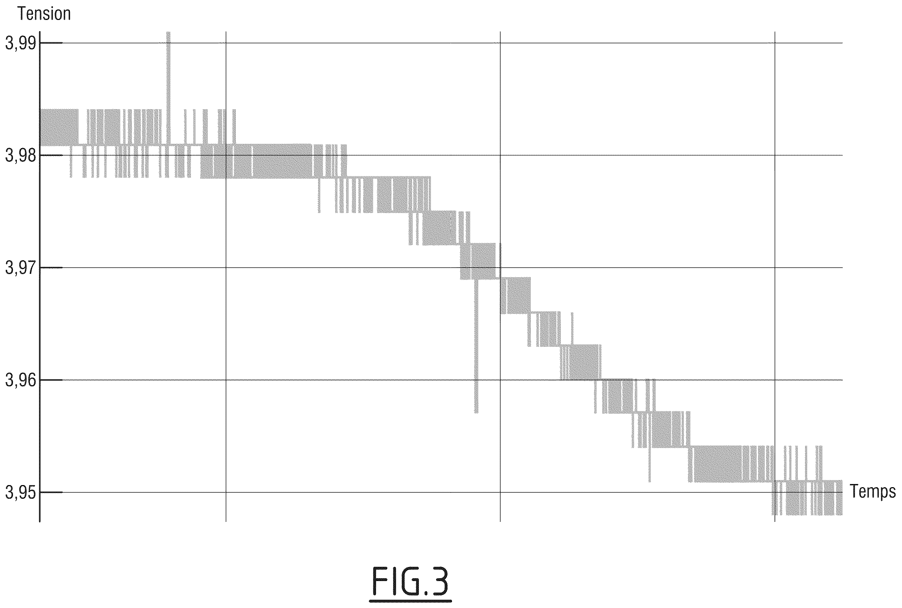

Un exemple de signal obtenu à l'issue de l'étape d'acquisition E30 est le signal bruité représenté sur la figure 3.

L'étape de filtrage E32 comporte une première sous-étape d'échantillonnage, une sous-étape de filtrage et une deuxième sous-étape d'échantillonnage.

Lors de la première sous-étape d'échantillonnage, le calculateur 22 échantillonne le signal de tension de l'élément électrochimique 12 (reçu du capteur de tension 18) selon un premier intervalle de temps d'échantillonnage.

Autrement formulé, le calculateur 22 lit à chaque premier intervalle de temps d'échantillonnage la valeur du signal de tension de l'élément électrochimique 12.

Selon l'exemple décrit, le premier intervalle de temps d'échantillonnage est compris entre 500 millisecondes (ms) et 2 secondes (s), typiquement égal à une seconde.

Le calculateur 22 obtient ainsi un premier signal échantillonné.

Lors de la sous-étape de filtrage, le calculateur 22 applique un premier filtre F1 sur le premier signal échantillonné.

Selon l'exemple décrit, le premier filtre F1 est un filtre de deuxième ordre.

Pour améliorer l'embarquabilité avec un calcul simple à réaliser, le premier filtre F1 est une cascade de deux sous-filtres du premier ordre, notés respectivement SF1 et SF2.

De préférence, chaque sous-filtre SF est représenté par l'équation suivante :

$$S_{SF}(n) = \frac{a_{SF}.S_{SF}(n-1) + e_{SF}(n)}{1 + a_{SF}}$$

Où :

- $S_{SF}(n)$ désigne la sortie du sous-filtre SF à l'instant n,
- $a_{SF}$ est un paramètre,
- $S_{SF}(n-1)$ désigne la sortie du sous-filtre SF à l'instant n-1, et
- $e_{SF}(n)$ désigne l'entrée du sous-filtre SF à l'instant n.

Cela permet de limiter la mémorisation à deux valeurs uniquement, à savoir la sortie du premier sous-filtre SF1 à l'instant n-1 et la sortie du deuxième sous-filtre SF2 à l'instant n-1.

Avantageusement, le paramètre $a_{SF}$ de chaque sous-filtre SF1 ou SF2 est ici une valeur comprise entre 5 et 15, par exemple égal à 10.

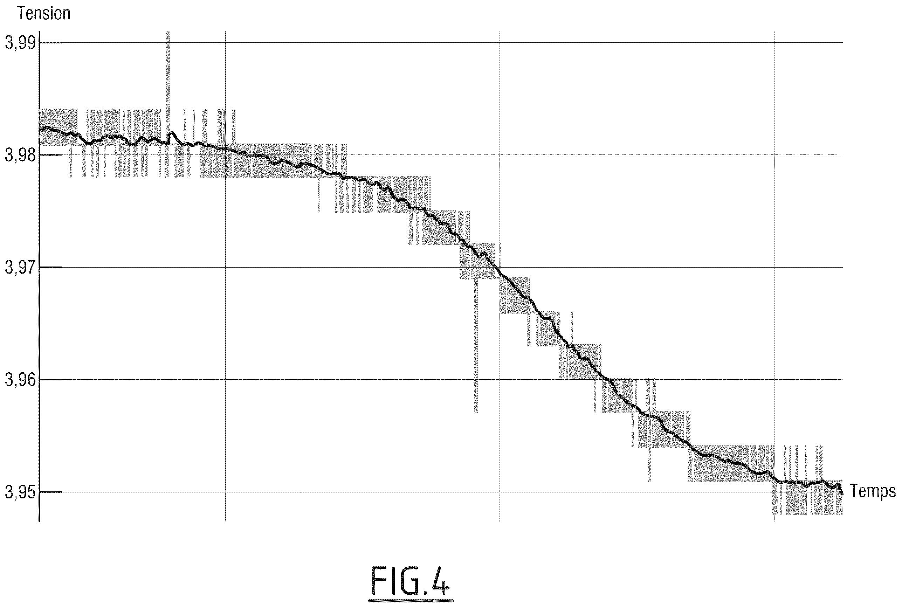

Une telle sous-étape de filtrage permet de lisser le signal de tension comme représenté sur la figure 4.

Lors de la deuxième sous-étape d'échantillonnage, le calculateur 22 échantillonne le signal filtré selon un deuxième intervalle de temps d'échantillonnage.

Cela signifie que le calculateur 22 lit à chaque deuxième intervalle de temps d'échantillonnage la valeur de la tension du signal filtré.

Selon l'exemple décrit, le deuxième intervalle de temps d'échantillonnage est compris entre 30 secondes (s) et 90 s, de préférence égal à une minute.

Le deuxième intervalle de temps d'échantillonnage est bien supérieur au premier intervalle de temps d'échantillonnage.

Il est ainsi obtenu un deuxième signal échantillonné.

La deuxième sous-étape d'échantillonnage se comporte comme un filtrage additionnel au filtre appliqué lors de la sous-étape de filtrage pour lisser encore davantage la tension.

Une telle deuxième sous-étape permet que la phase d'estimation P2 soit mise en œuvre à une fréquence plus faible. Ceci réduit ainsi la puissance de calcul nécessaire, ce qui améliore l'embarquabilité.

De plus, avec un faible nombre de points, il devient possible de traiter un très grand nombre d'éléments électrochimiques 12 en parallèle ce qui rend le procédé utilisable à l'échelle d'une batterie 10 complète.

Chaque intervalle de temps d'échantillonnage est réglable pour permettre une adaptation du procédé à l'application envisagée.

L'étape de dérivation E34 comporte une sous-étape de calcul et une sous-étape de filtrage.

Lors de la sous-étape de calcul, le calculateur 22 calcule la dérivée du deuxième signal échantillonné. Le calculateur 22 obtient ainsi un signal intermédiaire.

Pour cela, dans l'exemple décrit, le calculateur 22 calcule le rapport entre la variation de tension et la variation d'Ampères heures écoulés.

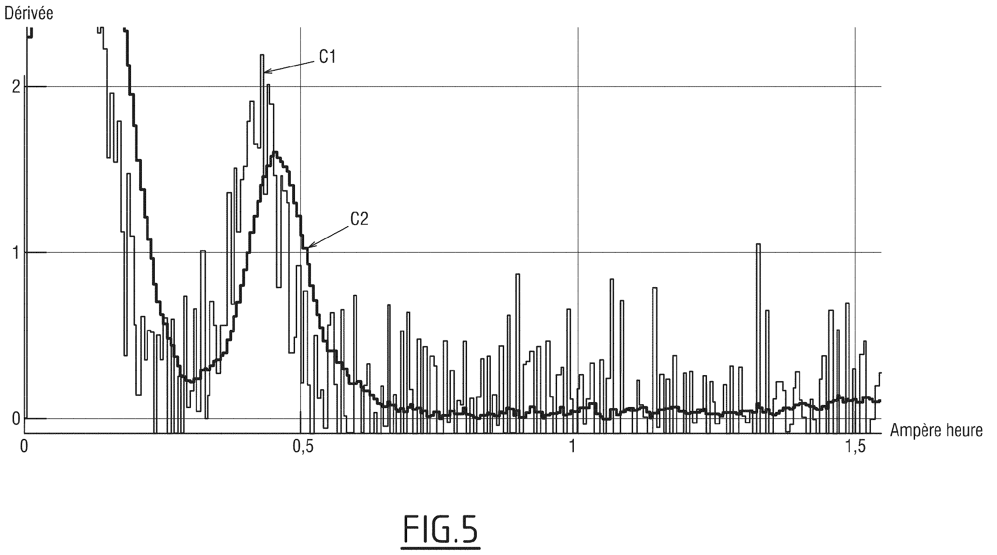

Un exemple de signal intermédiaire correspond à la courbe notée C1 sur la figure 5.

**EP 4 756 446 A1**

Lors de la sous-étape de filtrage, le calculateur 22 applique un deuxième filtre F2 sur le signal intermédiaire.

Avantageusement, le deuxième filtre F2 appliqué est un filtre du deuxième ordre comme le premier filtre F1.

Ainsi, le deuxième filtre F2 est également paramétré par un paramètre noté $a_{F2}$. Par exemple, le paramètre $a_{F2}$ du deuxième filtre F2 est égal à 3.

L'application du deuxième filtre F2 permet de lisser le signal intermédiaire pour obtenir un signal dérivé, tel que représenté sur la figure 5 en référence à la courbe indiquée C2.

L'étape de détection E36 de pics vise à détecter des pics dans le signal dérivé.

Selon l'exemple décrit, l'étape de détection E36 comprend une opération d'obtention d'une composante lente du signal dérivé, c'est-à-dire de la base du signal dont la variation est lente (par rapport aux transitions qui présentent une variation rapide).

La composante lente correspond ainsi à une moyenne de fond permettant de détecter un pic du fait que ce pic va se découper de manière plus significative, les pics faisant partie de la composante rapide du signal dérivé.

Une telle opération d'obtention comprend l'application d'un troisième filtre F3 sur le signal dérivé.

Le troisième filtre F3 est ici du même type que le premier filtre F1 et le deuxième filtre F2.

Ainsi, le troisième filtre F3 est aussi paramétré par un paramètre noté $a_{F3}$. Le paramètre $a_{F3}$ est choisi élevé, par exemple compris entre 10 et 20.

Le calculateur 22 sélectionne alors la valeur minimale entre la valeur du signal dérivé et la valeur obtenue par application du troisième filtre F3.

La réunion des valeurs minimales sélectionnées forme la moyenne de fond de sorte que la moyenne de fond n'est jamais plus élevée que le signal dérivé.

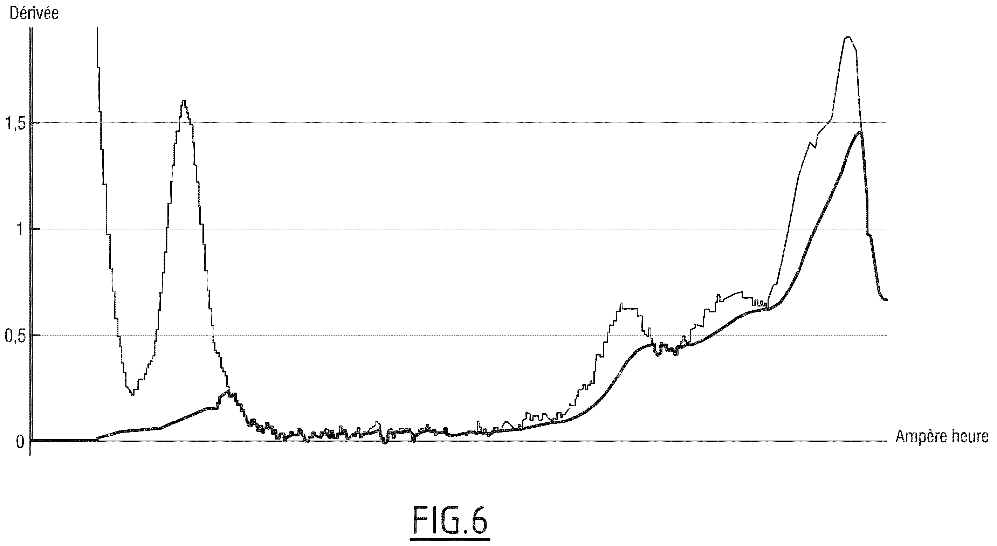

Comme visible sur la figure 6, la moyenne de fond présente un retard et un aplatissement par rapport au signal dérivé.

Ainsi que cela apparaîtra dans la suite, la moyenne de fond est un signal permettant de détecter un pic du fait que ce pic va se découper de manière plus significative, les pics faisant partie de la composante rapide du signal dérivé.

L'étape de détection E36 comporte également une opération de comparaison du signal dérivé avec la moyenne de fond.

Lorsque la différence en amplitude entre les deux signaux est comprise dans un intervalle prédéfini, il est détecté un intervalle de localisation potentielle d'un pic.

Un tel intervalle est dénommé zone d'intérêt dans ce qui suit.

L'intervalle prédéfini s'étend entre un seuil minimal et un seuil maximal.

La valeur des seuils est prédéfinie et dépend du pic considéré.

A titre d'exemple, pour le pic correspondant à la transition LiC6 de/vers LiC12, le seuil minimal correspond sur la figure 6 à une valeur de 0,3 (sans unité) et le seuil maximal est de 2,0 (sans unité).

Ces valeurs sont données pour le cas d'un courant de C/10, des fréquences d'échantillonnage de 1s et 60s et des paramètres pour les filtres de 10 et 3 respectivement.

En pratique, la valeur de la hauteur de dérivée associée aux pics dépend fortement de ces valeurs ainsi que du niveau de bruit.

Chaque zone d'intérêt va correspondre à des intervalles de temps durant lesquels la différence en amplitude respecte une condition liée au pic cherchée.

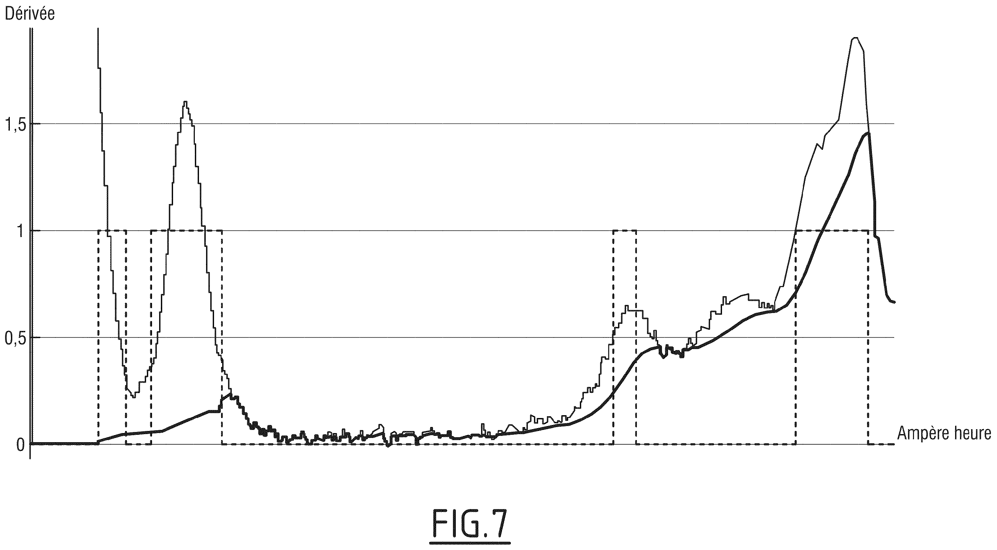

Dans l'exemple de la figure 7, quatre zones d'intérêt ont été déterminées.

Il peut être souligné ici que les zones d'intérêt respectent la condition associée à un pic proche.

Typiquement, la différence pour le pic de la deuxième zone d'intérêt sur la figure 7 (en comptant de gauche à droite) correspond à des seuils minimal et maximal plus élevés que le pic de la quatrième zone d'intérêt.

Aussi, la différence en amplitude dans la deuxième zone d'intérêt respecte un premier critère avec des seuils minimal et maximal relativement élevés alors que la différence en amplitude dans la quatrième zone d'intérêt respecte un deuxième critère différent du premier critère et impliquant un seuil minimal et un seuil maximal relativement faibles.

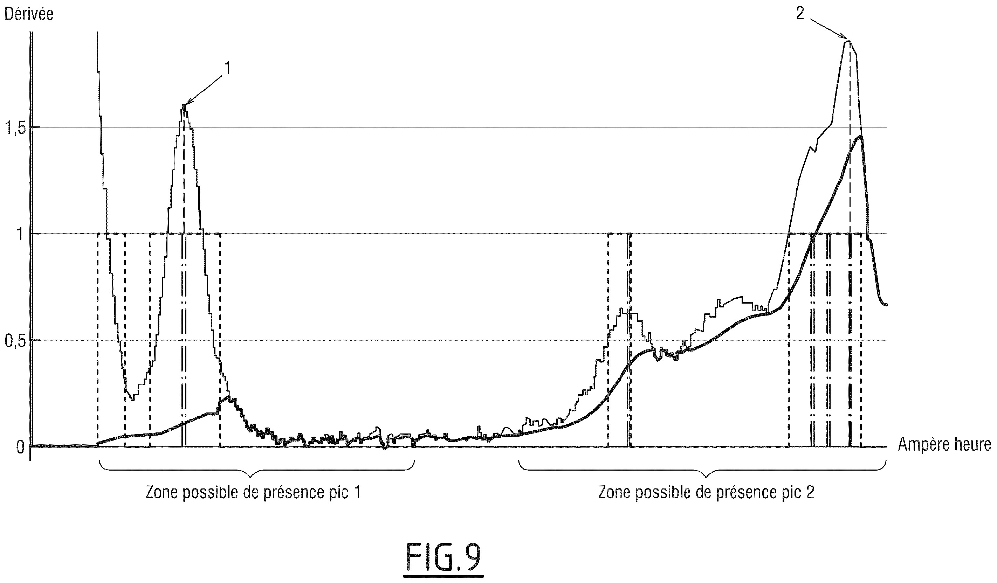

Dans l'exemple décrit, comme visible sur la figure 9, il y a deux pics potentiels et donc deux zones possibles de présence d'un pic différentes correspondant à deux critères locaux différents.

Cela signifie qu'au fil du temps, on vient comparer la valeur du signal dérivé avec la moyenne de fond et, dès que le critère local est respecté, une zone d'intérêt est ouverte jusqu'à ce que le critère local ne soit plus respecté et la zone d'intérêt est fermée.

Une zone d'intérêt est ainsi délimitée par une première délimitation correspondant au premier instant auquel le critère est respecté et une deuxième délimitation correspondant au dernier instant auquel le critère est respecté.

Pour préciser ce point, dans la zone possible de présence d'un pic 1, il est utilisé un premier critère local et il se trouve que la première zone d'intérêt et la deuxième zone d'intérêt sont les seules zones où ce premier critère local est respecté.

Puis, dans la zone possible de présence d'un pic 1, il est utilisé un deuxième critère local (différent du premier critère), ce qui conduit à identifier la troisième zone d'intérêt et la quatrième zone d'intérêt comme les seules zones où ce

7

deuxième critère local est respecté.

A l'issue de l'opération de comparaison, il est ainsi obtenu quatre zones d'intérêt susceptibles de contenir un pic.

Ces zones d'intérêt sont à mettre au regard du fait qu'en réalité, seuls deux pics sont attendus.

Il convient donc de déterminer les zones d'intérêt parmi les quatre zones d'intérêt présentant effectivement un des deux pics attendus.

Pour cela, l'étape de détection E36 comporte ensuite une opération de détermination de la présence effective ou non d'un pic dans les zones d'intérêt obtenues.

Pour cela, il est vérifié si le pic potentiel est conforme à une ou plusieurs caractéristiques attendues.

Par exemple, la largeur du pic potentiel est comparée à une largeur attendue ou la position du pic potentiel est comparée à un intervalle de position attendue.

Ces caractéristiques sont établies par des essais conduisant à donner une table associant à chaque transition une caractéristique, soit sous forme d'un intervalle représentatif de la variation de la caractéristique au cours du vieillissement soit sous forme d'une valeur, notamment lorsque la variation de la caractéristique est faible au cours du vieillissement.

Lorsque le pic potentiel ne respecte pas une caractéristique attendue, la zone d'intérêt est écartée.

Un premier exemple de caractéristique est la largeur du pic.

Une mise en œuvre préférée est de comparer la largeur de la zone d'intérêt avec la largeur attendue.

Lorsque la zone d'intérêt n'est pas assez large, cela implique que la zone d'intérêt ne comporte pas de pic correspondant à une transition.

Avec ce critère, dans l'exemple décrit, la première zone et la troisième zone sont éliminées car elles ne sont pas assez étendues.

Un deuxième exemple de caractéristique est la nature de la variation du signal dérivé dans la zone d'intérêt.

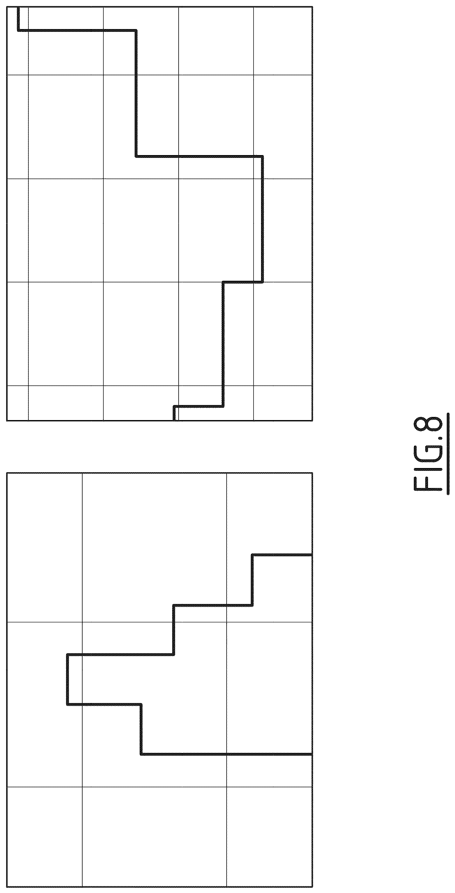

Pour cela, comme illustré par la partie gauche de la figure 8, il peut être fait une recherche de pic par concordance de motifs sur trois valeurs consécutives du signal dérivé.

La recherche de la forme de pic implique ainsi la comparaison de 3 valeurs du signal dérivé, prises de manière contiguë dans le temps à un instant n-2, un instant n-1, et un instant n. L'itération suivante voit ces valeurs évoluer comme suit : la valeur à l'instant n-2 est oubliée, la valeur à l'instant n-1 devient la valeur à l'instant n-2, la valeur à l'instant n devient la valeur à l'instant n-1 et la valeur à l'instant n est la valeur courante du signal dérivé.

Un pic est détecté par recherche de motif lorsque l'inéquation suivante est vérifiée :

$$\text{Signal dérivé (n-2)} < \text{Signal dérivé (n-1)} > \text{Signal dérivé (n)}$$

Dans l'exemple décrit, la première zone d'intérêt ne vérifie pas ce critère puisque le signal dérivé diminue de manière monotone dans cette zone d'intérêt.

L'étape de détection E36 permet ainsi d'obtenir la position du pic.

La position du pic est un exemple de valeur d'un paramètre relatif au pic pouvant être détecté dans le signal dérivé.

La phase d'estimation P2 vise à estimer la capacité à partir de la position des pics détectés lors de la phase de détection P1.

La phase d'estimation P2 comporte une étape de correction E38 et une étape de déduction E40.

Lors de l'étape de correction E38, le calculateur 22 cherche à obtenir la position réelle des pics détectés.

Une première correction est une compensation des retards introduits par les filtres utilisés.

Pour cela, il est calculé le retard introduit qui est ensuite converti en Ah en utilisant le fait que le courant est constant. Ce retard converti est soustrait à la position détectée du pic.

Un deuxième exemple de correction est lié au fait que la position initiale n'est pas toujours connue puisqu'elle est généralement exprimée en état de charge initiale $SOC_{init}$.

Pour cela, on appliquera une correction $\Delta Ah_{init}$ selon la formule suivante :

$$\Delta Ah_{init} = \left(\frac{SOC_{init} - 100}{100}\right) \frac{\alpha . Ah_{mes} + \beta}{1 - \left(\frac{SOC_{init} - 100}{100}\right) . a}$$

Où:

• $\alpha$ et $\beta$ sont des paramètres d'un modèle linéaire liant la position absolue $Ah_{abs}$ des pics (après compensation) et la capacité $Q_{pic}$, c'est-à-dire qu'il vient :

$$Q_{pic} = \alpha . Ah_{abs} + \beta$$

Ces paramètres $\alpha$ et $\beta$ sont supposés connus, par exemple par une table.

• $Ah_{mes}$ désigne la valeur mesurée de la position des pics (celle à compenser).

Dans ce modèle, il est également supposé que la relation entre la capacité $Q_{pic}$ et la position absolue $Ah_{abs}$ soit linéaire, ce qui est généralement vrai.

Dans certains modes de réalisation, un modèle plus élaboré que le modèle linéaire précédent peut être utilisé.

Lors de l'étape de déduction E40, le calculateur 22 utilise une table associant la position réelle du ou des pics à la valeur de la capacité.

La phase de détection P1 qui vient d'être décrite peut être mise en œuvre en environnement très bruité grâce à l'emploi d'une pluralité de filtres. Cela rend cette détection compatible avec des capteurs comportant un convertisseur analogique-numérique avec de mauvaises performances. Cette détection fonctionne également en présence de biais d'un ou plusieurs capteurs ou de problèmes de perturbations électromagnétiques.

La phase de détection P1 permet ainsi de réaliser un relevé précis des positions des transitions de phases de tout élément électrochimique 12 de la batterie 10 en environnement bruité.

Ce relevé est compatible avec une implémentation embarquée du fait de la faible charge calculatoire. En particulier, la combinaison de plusieurs filtres avec deux techniques d'échantillonnage à des fréquences différentes permet de limiter fortement les ressources impliquées.

De plus, la phase de détection P1 peut être réalisée en temps réel.

Cela rend également possible d'envisager de mettre en œuvre la phase de détection P1 pour un grand nombre d'éléments électrochimiques 12.

Des expériences réalisées par la demanderesse ont montré qu'une telle possibilité de caractérisation à la volée des pics permet d'obtenir une bonne estimation de la capacité de chaque élément électrochimique 12.

En effet, comme une pleine décharge ou charge n'est pas indispensable, il est possible de déterminer la capacité de chaque élément électrochimique 12 sans attendre que l'élément électrochimique 12 de capacité la plus faible n'atteigne ses limites.

Bien entendu, la phase d'estimation P2 peut être mise en œuvre pour estimer d'autres paramètres représentatifs du vieillissement de l'élément électrochimique 12.

Par exemple, il est possible de déterminer la résistance pour chaque élément électrochimique 12.

Dans certains modes de réalisation, la phase d'estimation P2 peut également fournir une incertitude de l'estimation.

L'incertitude est ici liée à la mesure de l'état de charge et au fait que le signal dérivé n'est calculé que sur la base des échantillons du signal mesuré.

Concernant l'incertitude de ces deux sources, il est possible d'en déduire l'incertitude résultante sur la capacité déduite.

Un résultat obtenu pour les deux pics des figures précédentes obtenus par simulation donne les résultats suivants pour un élément électrochimique de capacité 26,25 Ah :

[Table 1]

|  | *Pic 1* | *Pic 2* |
|---|---|---|
| Position du pic | -3,912 Ah | -20,21 Ah |
| Capacité inférée | 26,45 Ah | 26,19 Ah |
| Incertitude | $\pm$ 0,26 Ah | $\pm$ 0,24 Ah |

La capacité fusionnée des 2 estimations provenant de chacun des pics est de 26,32 Ah et l'incertitude associée de $\pm$ 0,25 Ah.

Celle-ci est calculée en pondérant le résultat pour favoriser la capacité intermédiaire dont l'incertitude est la plus faible (précision), sans toutefois ignorer la capacité intermédiaire la plus incertaine (robustesse).

L'erreur par rapport à la valeur vraie est de 0,07 Ah, ce qui est à l'intérieur de l'incertitude.

En ce qui concerne la robustesse, elle est obtenue malgré le fait que la mesure de tension de l'élément électrochimique est bruitée et surtout crénelée dû à l'acquisition opérée par le convertisseur analogique/numérique.

Une telle phase de détection P1 est également utilisable pour d'autres exploitations des pics détectés.

Par exemple, la phase de détection P1 peut servir à déterminer la relation liant la variation de la tension en circuit ouvert à l'état de charge pour mettre à jour un algorithme d'estimation de l'état de charge qui aurait dévié.

La phase de détection P1 peut également servir d'entrée pour une inférence des modes de dégradation de l'élément électrochimique 12.

En outre, la phase de détection P1 n'est pas nécessairement limitée à la détection de pics.

En particulier, la phase de détection P1 peut détecter des vallées.

La partie droite de la figure 8 illustre le cas de figure pour détecter une vallée où seule l'inéquation à vérifier change par rapport à ce qui a été décrit précédemment, celle-ci s'écrivant :

$$\text{Signal dérivé } (n-2) > \text{Signal dérivé } (n-1) < \text{Signal dérivé } (n)$$

Plus généralement, la phase de détection P1 peut être utilisée pour détecter tout type de motifs dans la dérivée de la tension.

Par exemple, la phase de détection P1 peut être utilisée pour détecter le début d'un plateau dans le signal de tension.

Cela peut être notamment utile pour le calcul de la résistance.

Il convient également d'indiquer ici que le procédé d'analyse décrit l'a été dans le cas particulier d'une analyse DVA correspondant à l'analyse de la dérivée de la tension par rapport aux Ampères-heures.

Toutefois, il est envisageable d'utiliser une mise en œuvre similaire pour analyser la variation d'une dérivée de grandeurs physiques différentes.

Selon un exemple particulier, le procédé d'analyse peut être utilisé pour analyser la dérivée de la quantité de charge accumulée (Ampères-heures) par rapport à la tension.

Il suffit en effet de réaliser les mêmes opérations mais sur un signal temporel différent, à savoir celui de la première grandeur physique.

Pour l'exemple de la DVA, cette première grandeur physique est la tension.

IL pourrait également être envisagé de mettre en œuvre le procédé dans le cadre de décharge ou de charge avec une puissance constante.

Une puissance égale à ¼ ou 1/10 de la puissance nominale sont des exemples de valeurs de puissance qui peuvent être utilisés dans une telle mise en œuvre à puissance constante.

**Revendications**

1. Procédé d'analyse de la dérivée d'une première grandeur électrique relative à au moins un élément électrochimique (12) d'une batterie (10) par rapport à une deuxième grandeur électrique relative à l'au moins un élément électrochimique (12) lors d'une charge ou d'une décharge à courant constant ou puissance constante, le procédé d'analyse étant mis en œuvre par un calculateur (22) d'un système de gestion (14) de l'au moins un élément électrochimique (12), le procédé d'analyse comprenant les étapes de :

   - obtention d'un signal temporel de la première grandeur électrique relative à l'au moins un élément électrochimique (12),
   - échantillonnage du signal temporel obtenu selon un premier intervalle de temps d'échantillonnage pour obtenir un premier signal échantillonné,
   - filtrage du premier signal échantillonné, pour obtenir un signal filtré,
   - échantillonnage du signal filtré selon un deuxième intervalle de temps d'échantillonnage, pour obtenir un deuxième signal échantillonné, le deuxième intervalle de temps d'échantillonnage étant strictement supérieur au premier intervalle de temps d'échantillonnage,
   - dérivation du deuxième signal échantillonné par rapport à la deuxième grandeur électrique, pour obtenir un signal dérivé présentant une composante lente et une composante rapide, et
   - détection d'une valeur d'un paramètre relatif à au moins un motif prédéfini dans le signal dérivé, la détection comprenant l'obtention de la composante lente du signal dérivé par application d'un filtre sur le signal dérivé, la présence éventuelle d'un motif prédéfini étant déterminée en utilisant la composante lente obtenue.

2. Procédé d'analyse selon la revendication 1, dans lequel l'étape de dérivation comporte une sous-étape de calcul de la dérivée, pour obtenir un signal intermédiaire et une sous-étape de filtrage du signal intermédiaire par application d'un filtre (F2), pour obtenir le signal dérivé.

3. Procédé d'analyse selon la revendication 1 ou 2, dans lequel l'étape de détection comporte l'obtention de zones d'intérêt où le motif prédéfini est potentiellement présent par détermination des instants durant lesquels une condition portant sur la différence entre le signal dérivé et le minimum entre la composante lente du signal dérivée et le signal dérivé est vérifiée.

4. Procédé d'analyse selon la revendication 3, dans lequel l'étape de détection comporte la détermination de la présence effective ou non d'un motif prédéfini dans les zones d'intérêt obtenues par vérification si le motif prédéfini potentiellement présent respecte une ou plusieurs caractéristiques attendues, une caractéristique étant de préférence relative à la largeur de la zone d'intérêt.

5. Procédé d'analyse selon l'une quelconque des revendications 1 à 4, dans lequel le paramètre relatif à au moins un motif prédéfini dont la valeur est détectée lors de l'étape de détection est la position du motif prédéfini.

6. Procédé d'analyse selon l'une quelconque des revendications 1 à 5, dans lequel, lors de l'étape de filtrage, il est utilisé un filtre d'ordre deux (F1).

7. Procédé d'analyse selon la revendication 6, dans lequel le filtre d'ordre deux (F1) est la composée de deux sous-filtres (SF1, SF2) d'ordre un et identiques.

8. Procédé d'analyse selon la revendication 7, dans lequel chaque sous-filtre (SF1, SF2) présente la fonction de filtrage suivante :

$$S_{SF}(n) = \frac{a_{SF}.S_{SF}(n-1) + e_{SF}(n)}{1 + a_{SF}}$$

Où :

- $S_{SF}(n)$ désigne la sortie du sous-filtre (SF1, SF2) à l'instant n,
- $a_{SF}$ est un paramètre,
- $S_{SF}(n - 1)$ désigne la sortie du sous-filtre (SF1, SF2) à l'instant n-1, et
- $e_{SF}(n)$ désigne l'entrée du sous-filtre (SF1, SF2) à l'instant n.

9. Procédé d'analyse selon les revendications 2 et 8, dans lequel le filtre appliqué à la sous-étape de filtrage et le filtre appliqué à l'étape de filtrage sont chacun composés des mêmes sous-filtres dont seul le paramètre des sous-filtres varie.

10. Procédé d'analyse selon l'une quelconque des revendications 1 à 9, dans lequel l'une des deux grandeurs électriques est la quantité de charge et l'autre grandeur électrique est la tension.

11. Procédé d'estimation d'un paramètre relatif à l'état de santé d'au moins un élément électrochimique (12) d'une batterie (10), le procédé d'estimation étant mis en œuvre par un calculateur (22) d'un système de gestion (14) de l'au moins un élément électrochimique (12), le procédé d'estimation comprenant les étapes de :

- mise en oeuvre d'un procédé d'analyse de la dérivée d'une première grandeur électrique relative à au moins un élément électrochimique (12) par rapport à une deuxième grandeur électrique relative à l'au moins un élément électrochimique (12) lors d'une charge ou d'une décharge à courant constant, pour obtenir au moins une valeur d'un paramètre relatif à au moins un motif prédéfini dans la dérivée de la première grandeur électrique, le procédé d'analyse étant un procédé selon l'une quelconque des revendications 1 à 10, et
- estimation d'un paramètre relatif à l'état de santé d'au moins un élément électrochimique (12) d'une batterie (10) à partir de l'au moins un paramètre relatif à au moins un motif prédéfini dans la dérivée de la première grandeur électrique.

12. Procédé selon l'une quelconque des revendications 1 à 11, dans lequel l'au moins un élément électrochimique présente au moins une transition de phase.

13. Procédé selon l'une quelconque des revendications 1 à 12, dans lequel l'au moins un élément électrochimique (12) comprend un matériau actif cathodique comprenant un phosphate lithié de fer, un phosphate lithié de manganèse et de fer ou un fluoro-phosphate lithié de vanadium.

**14.** Procédé selon l'une quelconque des revendications 1 à 12, dans lequel l'au moins un élément électrochimique (12) comprend un matériau actif anodique comprenant du graphite.

**15.** Calculateur (22) propre à analyser la dérivée d'une première grandeur électrique relative à au moins un élément électrochimique (12) d'une batterie (10) par rapport à une deuxième grandeur électrique relative à l'au moins un élément électrochimique (12) lors d'une charge ou d'une décharge à courant constant ou puissance constante, le calculateur (22) faisant partie d'un système de gestion (14) de l'au moins un élément électrochimique (12), le calculateur (22) étant propre à :

    - obtenir un signal temporel de la première grandeur électrique relative à l'au moins un élément électrochimique (12),
    - échantillonner le signal temporel obtenu selon un premier intervalle de temps d'échantillonnage pour obtenir un premier signal échantillonné,
    - filtrer le premier signal échantillonné, pour obtenir un signal filtré,
    - échantillonner le signal filtré selon un deuxième intervalle de temps d'échantillonnage, pour obtenir un deuxième signal échantillonné, le deuxième intervalle de temps d'échantillonnage étant strictement supérieur au premier intervalle de temps d'échantillonnage,
    - dériver le deuxième signal échantillonné par rapport à la deuxième grandeur électrique, pour obtenir un signal dérivé présentant une composante lente et une composante rapide, et
    - détecter une valeur d'un paramètre relatif à au moins un motif prédéfini dans le signal dérivé en obtenant la composante lente du signal dérivé par application d'un filtre sur le signal dérivé, la présence éventuelle d'un motif prédéfini étant déterminée en utilisant la composante lente obtenue.

**16.** Calculateur (22) propre à estimer un paramètre relatif à l'état de santé d'au moins un élément électrochimique (12) d'une batterie (10), le calculateur (22) faisant partie d'un système de gestion (14) de l'au moins un élément électrochimique (12), le calculateur (22) étant propre à :

    - mettre en œuvre un procédé d'analyse de la dérivée d'une première grandeur électrique relative à au moins un élément électrochimique (12) par rapport à une deuxième grandeur électrique relative à l'au moins un élément électrochimique (12) lors d'une charge ou d'une décharge à courant constant, pour obtenir au moins une valeur d'un paramètre relatif à au moins un motif prédéfini dans la dérivée de la première grandeur électrique, le procédé d'analyse étant un procédé selon l'une quelconque des revendications 1 à 10, et
    - estimer un paramètre relatif à l'état de santé d'au moins un élément électrochimique (12) d'une batterie (10) à partir de l'au moins un paramètre relatif à au moins un motif prédéfini dans la dérivée de la première grandeur électrique.

**17.** Système de gestion (14) d'au moins un élément électrochimique (12) d'une batterie (10), l'au moins un élément électrochimique (12) présentant des bornes, le système de gestion (14) comprenant :

    - un capteur de courant (16) propre à mesurer le courant fourni par ledit au moins un élément électrochimique (12),
    - un capteur de tension (18) propre à mesurer la tension aux bornes de l'au moins un élément électrochimique (12), et
    - un calculateur (22) selon la revendication 15 ou 16.

**18.** Batterie (10) comprenant :

    - au moins un élément électrochimique (12), et
    - un système de gestion (14) selon la revendication 17.

10

12

16

18

20

22

14

# FIG.1

```
        ┌─────────┐
  ⎧     │   E30   │
  │     └────┬────┘
  │     ┌────┴────┐
  │     │   E32   │
  │     └────┬────┘
P1 ⎨    ┌────┴────┐
  │     │   E34   │
  │     └────┬────┘
  │     ┌────┴────┐
  │     │   E36   │
  ⎩     └────┬────┘
  ⎧     ┌────┴────┐
  │     │   E38   │
P2 ⎨    └────┬────┘
  │     ┌────┴────┐
  ⎩     │   E40   │
        └─────────┘
```

<u>FIG.2</u>

EP 4 756 446 A1

Tension

3,99

3,98

3,97

3,96

3,95

Temps

<u>FIG.3</u>

EP 4 756 446 A1

FIG.4

FIG.5

EP 4 756 446 A1

FIG.6

FIG.7

EP 4 756 446 A1

FIG.8

FIG.9

Europäisches
Patentamt

European
Patent Office

Office européen
des brevets

# RAPPORT DE RECHERCHE EUROPEENNE

Numéro de la demande

EP 25 22 0528

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | JP 7 531699 B2 (MITSUBISHI ELECTRIC CORP) 9 août 2024 (2024-08-09) | 1,2,5-18 | INV. |
| A | * alinéas [0001], [0018] - alinéa [0103]; figures 1,2,5,6,7,10 * | 3,4 | G01R31/367 |
| | * alinéa [0126] - alinéa [0154] * ----- | | G01R31/392 |
| A | CN 114 355 223 A (DONGSOFT GROUP SHARE LTD COMPANY; DONGSOFT GROUP DALIAN LTD COMPANY) 15 avril 2022 (2022-04-15) * alinéa [0072] - alinéa [0118]; figures 1,2,5 * * alinéas [0134], [0179] - alinéa [0182] * ----- | 1-18 | |
| A | JP 2017 227539 A (YOKOGAWA ELECTRIC CORP) 28 décembre 2017 (2017-12-28) * le document en entier * ----- | 1-18 | |
| A | LI YI ET AL: "A quick on-line state of health estimation method for Li-ion battery with incremental capacity curves processed by Gaussian filter", JOURNAL OF POWER SOURCES, vol. 373, 7 novembre 2017 (2017-11-07), pages 40-53, XP085291353, ISSN: 0378-7753, DOI: 10.1016/J.JPOWSOUR.2017.10.092 * Section 2. - Section 5.3 * ----- | 1-18 | |
| A | CN 112 578 296 A (BYD CO LTD; SHENZHEN BYD LITHIUM BATTERY CO LTD) 30 mars 2021 (2021-03-30) * alinéas [0001], [0024] - alinéa [0072]; figures 1-4 * ----- | 1-18 | |

**DOMAINES TECHNIQUES RECHERCHES (IPC)**

G01R

Le présent rapport a été établi pour toutes les revendications

| Lieu de la recherche | Date d'achèvement de la recherche | Examinateur |
|---|---|---|
| Munich | 11 décembre 2025 | Hof, Klaus-Dieter |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 22 0528

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-12-2025

| Document brevet cité au rapport de recherche | | Date de publication | Membre(s) de la famille de brevet(s) | | Date de publication |
|---|---|---|---|---|---|
| JP 7531699 | B2 | 09-08-2024 | DE | 112021007656 T5 | 29-02-2024 |
| | | | JP | 7531699 B2 | 09-08-2024 |
| | | | JP | WO2022239188 A1 | 17-11-2022 |
| | | | US | 2024288498 A1 | 29-08-2024 |
| | | | WO | 2022239188 A1 | 17-11-2022 |
| CN 114355223 | A | 15-04-2022 | AUCUN | | |
| JP 2017227539 | A | 28-12-2017 | CN | 107526038 A | 29-12-2017 |
| | | | JP | 6477610 B2 | 06-03-2019 |
| | | | JP | 2017227539 A | 28-12-2017 |
| CN 112578296 | A | 30-03-2021 | AUCUN | | |

EPO FORM P0460